# EUROPEAN PATENT SPECIFICATION

(11) **EP 1 655 767 B1**
(45) Date of publication and mention of the grant of the patent: **22.03.2017**
(21) Application number: 05447233.7
(22) Date of filing: 13.10.2005
(51) Int. Cl.: H01L 21/02, H01L 21/316

(54) **Method for making a passivated semiconductor substrate**
Verfahren zur Herstellung eines passivierten Halbleitersubstrats
Méthode pour faire un substrat semi-conducteur passivé

(30) Priority: 13.10.2004 US 618863 P
(43) Date of publication of application: 10.05.2006
(73) Proprietor: IMEC, 3001 Leuven (BE)
(72) Inventor: Caymax, Matty, 3001 Leuven (BE); Bonzom, Renaud, 31530 Lévignac sur Save (FR); Leys, Frederik, 9000 Gent (BE); Meuris, Marc, 3140 Keerbergen (BE)
(74) Representative: Van Malderen, Joëlle

(56) References cited:
- US-A- 5 036 374
- US-A- 5 168 330
- US-A1- 2002 173 130
- US-A1- 2003 082 300
- US-B1- 6 352 942
- VITKAVAGE D J ET AL: "GATING OF GERMANIUM SURFACES USING PSEUDOMORPHIC SILICON INTERLAYERS" APPLIED PHYSICS LETTERS, AIP, AMERICAN INSTITUTE OF PHYSICS, MELVILLE, NY, US, vol. 53, no. 8, 22 August 1988 (1988-08-22), pages 692-694, XP000047869 ISSN: 0003-6951
- FOUNTAIN G G ET AL INSTITUTE OF PHYSICS: "UNPINNING THE GAAS SURFACE USING A NOVEL PSEUDOMORPHIC INSULATOR STRUCTURE" GALLIUM ARSENIDE AND RELATED COMPOUNDS. GEORGIA, 11 - 14 SEPT., 1988, PROCEEDINGS OF THE INTERNATIONAL SYMPOSIUM ON GALLIUM ARSENIDE AND RELATED COMPOUNDS. (TITLE FROM 1994 ONWARDS: PROCEEDINGS OF THE INTERNATIONAL SYMPOSIUM ON COMPOUND SEMICONDUCTOR, vol. SYMP. 15, 11 September 1988 (1988-09-11), pages 375-380, XP000089572
- NAN WU ET AL: "A novel surface passivation process for HfO2 Ge MOSFETs" DEVICE RESEARCH CONFERENCE, 2004. 62ND DRC. CONFERENCE DIGEST [LATE NEWS PAPERS VOLUME INCLUDED] NOTRE DAME, IN, USA JUNE 21-23, 2004, PISCATAWAY, NJ, USA,IEEE, 21 June 2004 (2004-06-21), pages 19-20, XP010748112 ISBN: 0-7803-8284-6
- FOUNTAIN G G ET AL: "ELECTRICAL AND MICROSTRUCTURAL CHARACTERISATION OF AN ULTRATHIN SILICON INTERLAYER USED IN A SILICON DIOXIDE/GERMANIUM-BASED MIS STRUCTURE" ELECTRONICS LETTERS, IEE STEVENAGE, GB, vol. 24, no. 16, 4 August 1988 (1988-08-04), pages 1010-1011, XP000577352 ISSN: 0013-5194
- REINKING D ET AL: "Fabrication of high-mobility Ge <E1>p</E1>-channel MOSFETs on Si substrates" ELECTRONICS LETTERS, IEE STEVENAGE, GB, vol. 35, no. 6, 18 March 1999 (1999-03-18), pages 503-504, XP006011932 ISSN: 0013-5194

## Description

### Field of the Invention

This invention relates to method for passivation of a semiconductor substrate comprising semiconductor material other than silicon.

It also relates to a semiconductor device comprising such passivated semiconductor substrate.

### State of the Art

In microelectronics industry, a lot of different semiconductor materials are used besides Silicon (Si). For example Germanium (Ge) wafers are important substrates with technological applications in optical devices and are recently introduced as a replacement for Si substrates for advanced Integrated Circuit (IC) devices. Ge has very attractive advantages such as high mobility and compatibility with high-k and III/V materials.

Galliumarsenide (GaAs) is another example of semiconductor materials, so-called III/V materials. These are often used in optical devices such as LED's, sensors, etc.

When processing wafers containing these alternative materials, dedicated process conditions have to be developed.

Especially in case of deposition of gate stacks on Ge, one has to deal with a lot of difficulties and challenges. One of the major problems here is the high interface states density (Nᵢₜ) at the interface between Ge substrate and gate dielectric, causing bad capacitance-voltage (C-V curve) and current density-voltage (I-V curve) device characteristics.

Also for analysis of mentioned alternative semiconductor materials, especially in case of Spreading Resistance measurements, the problem of high interface states density influences the measurement.

A few attempts to decrease the problem of high interface states density between Ge substrate and gate oxide are known in prior art.

In "A TaN-HfO2-Ge pMOSFET with novel SiH4 surface passivation", Wu et al. teach a method for passivating a Ge layer, wherein an amorphous interfacial layer is deposited in SiH₄ ambient.

In US 6,352,942 Luan et al. teach a method of oxidation of Si on Ge, wherein a 35nm polycrystalline Si layer was deposited and then oxidized by exposure to dry oxygen gas.

### Aim of the Invention

The present invention aims to provide a method for passivating a semiconductor substrate comprising semiconductor material other than silicon in relation to further IC processing.

### Summary of the Invention

The present invention relates to a method for passivating a semiconductor substrate comprising the steps of:
- providing a substrate surface comprising (or consisting of) a mono-crystalline semiconductor material, said material being different from silicon, and
- forming a silicon layer on the substrate surface, such that said silicon layer is lattice matched to said mono-crystalline semiconductor material.

The mono-crystalline semiconductor material can comprise or can consist of any semiconductor material other than silicon, more particularly can comprise or consist of Ge, GaAs, or any combination thereof.

In a method according to the present invention, the silicon layer constitutes passivation of said part of the substrate surface (of said mono-crystalline semiconductor material) in relation to subsequent IC processing.

In a method according to the present invention, the thickness of the formed silicon layer can be selected such that during and after at least one subsequent IC processing step the silicon layer constitutes passivation of said part of the substrate surface (of said mono-crystalline semiconductor material) in relation to further IC processing.

After said at least one subsequent IC processing step, the thickness can be 1 to 6 monolayers, 1 to 4 monolayers, 1 to 2 monolayers, or even 1 monolayer.

Subsequent IC processing can comprise a processing step such as but not limited to oxidation of a part of the silicon layer, formation of a dielectric layer stack, or formation of a gate stack.

A method according to the present invention further comprises the step of rendering the relevant part of the semiconductor substrate, in particular the mono-crystalline semiconductor material, substantially free of oxides before the step of forming the silicon layer.

In a method according to the present invention, the silicon layer can be formed by epitaxial growth.

Silane, dichlorosilane, trisilane, or the like, or a combination thereof can be used as silicon precursor(s).

H₂ can be used as carrier gas. Preferably N₂ can be used as carrier gas.

In a preferred method the silicon layer is formed with trisilane as silicon precursor and N₂ as carrier gas.

The present description describes further a passivated semiconductor substrate according to a method of the present invention.

This passivated semiconductor substrate can be used in a semiconductor device.

This passivated substrate surface can also be suitable to be measured by Spreading Resistance analysis techniques.

### Short Description of the Drawings

Figure 1: TEM picture of a high-k gate stack on Ge passivated with silicon.
Figure 2: Schematic description of a high-k gate stack on Ge passivated with silicon.
Figure 3: C-V measurement of a p-type Ge capacitor fabricated in 3 different ways.
Figure 4: I-V curve of a p-type Ge capacitor fabricated with and without epitaxial silicon layer.
Figure 5: Nᵢₜ comparison for Si passivated and NH₃ anneal passivated Ge n- and p-FETs.
Figure 6: Low field effective mobility µ_{eff} and corresponding Iₛ-V_{G} characteristics of 10µm and 0.15µm n-FETs.
Figure 7: Low field effective mobility µ_{eff} and corresponding I_{S}-V_{G} characteristics of 10µm and 0.15µm p-FETs.
Figure 8: SRP current-voltage profile with and without silicon passivation layer.

### Detailed Description of the Invention

To solve the problem of high interface states density, a method for making a passivated semiconductor substrate according to claim 1, is disclosed comprising the steps of providing a substrate surface comprising or consisting of a mono-crystalline semiconductor material other than silicon and forming a silicon layer on the substrate surface, such that the formed silicon layer is lattice matched to at least part of the substrate surface (in particular is lattice matched to said mono-crystalline semiconductor material).

The mono-crystalline semiconductor material can comprise or can consist of any semiconductor material other than Si, more particularly can comprise or consist of Ge, GaAs, or any combination thereof.

In a method according to the present invention, the silicon layer constitutes passivation of said part of the substrate surface (of said mono-crystalline semiconductor material) in relation to subsequent IC processing.

In the context of the present invention, passivation can be defined as making semiconductor material other than silicon chemically and electrically stable in relation to subsequent IC processing by reaction with silicon.

In a method according to the present invention, the thickness of the formed silicon layer can be selected such that during and after at least one subsequent IC processing step the silicon layer constitutes passivation of said part of the substrate surface in relation to further IC processing.

After said at least one subsequent IC processing step, the thickness can be 1 to 6 monolayers, 1 to 4 monolayers, 1 to 2 monolayers, or 1 monolayer. In case of Ge devices, after gate oxide formation 1 monolayer could be enough to avoid contact between Ge and the gate oxide and have minimal influence on the Equivalent Oxide Thickness (EOT).

The required silicon layer thickness can also be obtainable by providing a thicker layer than required, followed by oxidizing the silicon, or any other technique to decrease the silicon layer thickness, leaving the required number of monolayers of silicon. The required thickness can also be provided directly by a dedicated deposition process.

Forming the silicon layer lattice matched to the substrate surface (in particular to the mono-crystalline semiconductor material) can be done in different ways.

One way can be epitaxial growth of silicon.

Another possibility can be providing a non-epitaxial layer, followed by re-crystallization of the layer in order to make it lattice matched to the substrate surface.

The silicon layer could be provided by different chemical vapor deposition techniques using a silicon precursor e.g. silane, dichlorosilane, trisilane or the like. Preferably, epitaxial growth could be used, because this technique is able to form the silicon layer directly substantially lattice matched to the substrate surface.

In case of LPCVD epitaxial growth, the silicon precursor could be silane, dichlorosilane, trisilane or the like, or a combination thereof. As a carrier gas, H₂ or preferably N₂ could be used. The deposition temperature can be 300 to 600°C depending on the silicon precursor and pressure can be between 10 torr (13.3 mbar) and 100 torr (133.3 mbar). In a preferred method the silicon layer is formed with trisilane and N₂ as carrier gas at 300°C.

Rendering the semiconductor substrate surface substantially oxide free before forming the silicon layer could be done by subjecting the semiconductor surface to a solution containing HF, HBr, HI or any combination thereof, optionally followed by an annealing step in hydrogen ambient.

An additional advantage of the invention is that, in case of fabricating devices on semiconductor substrates other than silicon, the process flow can be simplified by changing it partially into IC processing on silicon.

### EXAMPLES

### Example 1:

In order to make a Ge capacitor, a gate stack is deposited on top of the Ge channel. To avoid a high interface state density at the interface between the Ge channel and the gate oxide, the Ge surface is passivated by forming a lattice matched monolayer of silicon on top of it. This is done by growing a few monolayers of mono-crystalline silicon in an epireactor, e.g. ASM epsilon, at a temperature between 500 and 575°C, with 20 to 50sccm silane, a pressure of 40 torr (53.3 mbar) and 10 to 40slm N₂ as carrier gas. This mono-crystalline silicon layer is formed lattice matched to the Ge.

In order to be able to grow epitaxially on the Ge surface and to remove substantially all germanium oxide on top of it, a surface preparation is done. Therefore, the Ge surface is subjected to a 1% HF solution, followed by anneal in H₂ ambient inside the chamber of the epireactor at a temperature between 650 and 850°C.

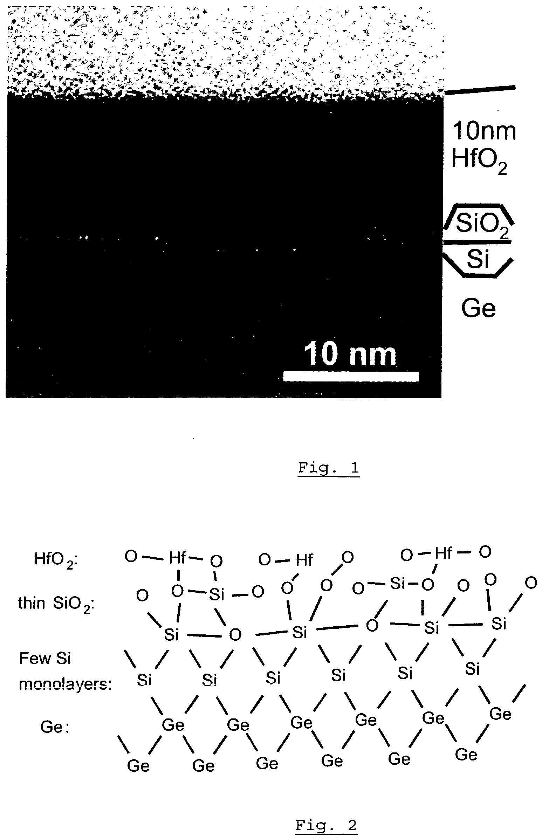

After the mono-crystalline growth of 4 to 5 monolayers of silicon, the gate oxide is fabricated. This is done by oxidizing the silicon layer thermally, thereby leaving 1 to 2 monolayers of silicon between the Ge and the gate oxide, followed by depositing High-k material. Figure 1 shows a TEM picture of the resulting structure. Figure 2 describes such structure schematically.

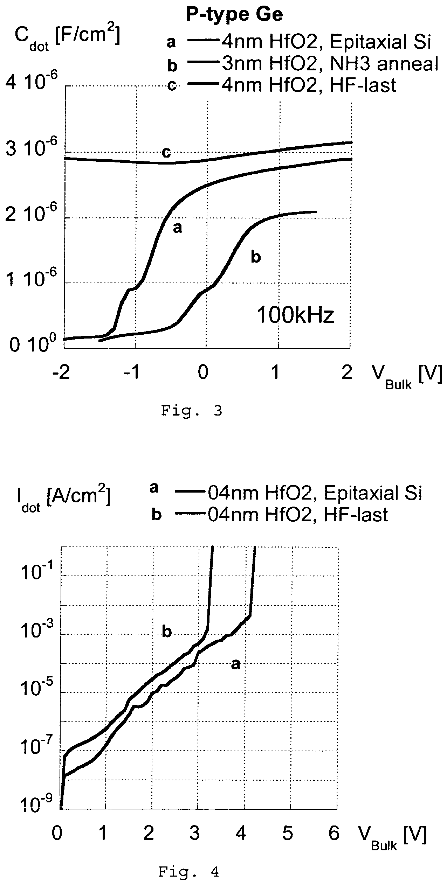

Figure 3 shows a C-V measurement of a p-type Ge capacitor fabricated in 3 different ways. In case an epitaxial silicon layer is present between the Ge and the gate oxide, the C-V curve shows a much more pronounced slope compared to the cases where this silicon layer is not present. This indicates that, in case of the presence of the silicon layer, the interface states density (Nᵢₜ) at the Ge/gate oxide interface is decreased. Figure 4 shows the I-V curve of a p-type Ge capacitor fabricated with and without epitaxial silicon layer. In case the silicon layer is present, the breakdown voltage increases approximately 1 Volt.

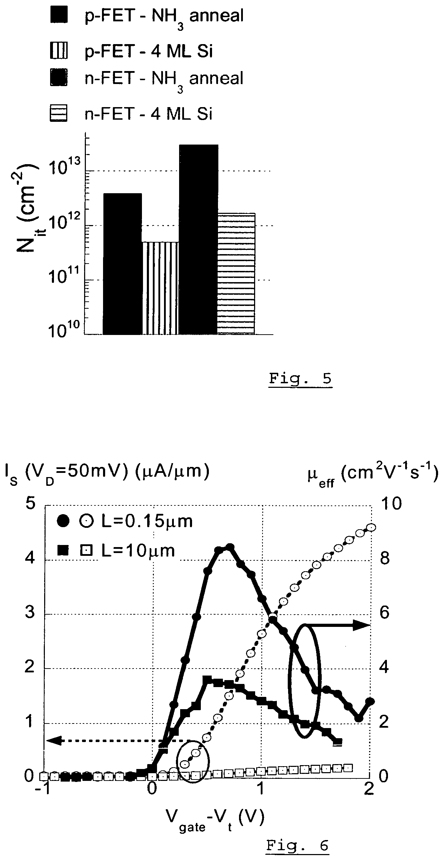

Also 10µm*10µm Ge n- and p-FET devices with four monolayers of silicon are fabricated. Charge pumping measurements on these devices confirm the reduced amount of Nᵢₜ as compared to an NH₃ anneal passivation treatment, which is a commonly used technique. In figure 5 is shown that the reduction is about one decade, yielding values of 5e11cm⁻² for p-FET and 1.5e12cm⁻² for n-FET.

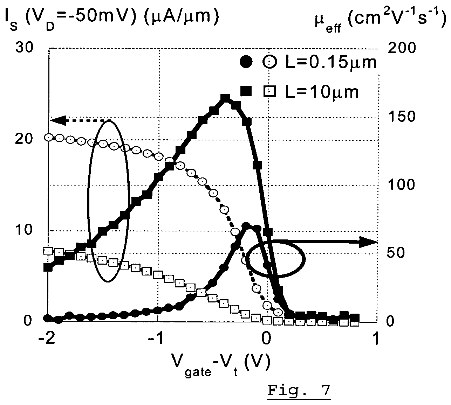

As a consequence of the lower Nᵢₜ, device lots with Si passivation yield promising deep-sub micron n- and p-FET devices. Their low field effective mobility µ_{eff} and corresponding I_{S}-V_{G} characteristics are shown in fig. 6 and 7. The p-FET mobility obtained in silicon passivated conventional 10µm and 0.15µm devices is in line with the values obtained with NH₃ or PH₃ passivation on ring-shaped long channel devices (table 1). The n-FET mobility is still low, although significantly superior to the data published for NH₃ passivation. Good n-FET mobility has only been reported for the PH₃ passivation.

Table 1: comparison of the low field mobility µ_{eff} and the EOT between silicon passivated devices and relevant publications for p- and n-FETs.

| | p-FET | | n-FET | |
|---|---|---|---|---|
| | µ_{eff}(cm²/Vs) | EOT (A) | µ_{eff}(cm²/Vs) | EOT (Å) |
| Si passivated | 170 | 26 | 10 | 26 |
| NH3 | 210 | 16 | ∼0.2 | ? |
| PH3 | 125 | 17? | 300 | 17? |

### Example 2:

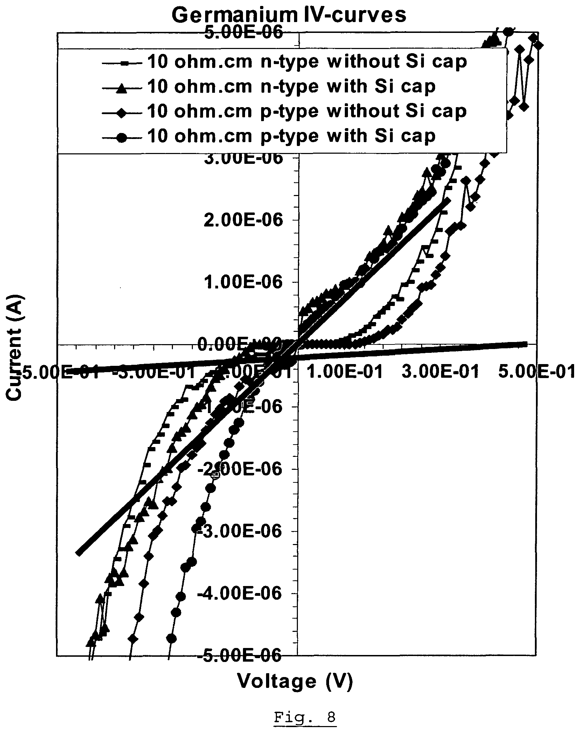

In case of Spreading Resistance analysis, e.g. SRP (Spreading Resistance Probing) and SSRM (Scanning Spreading Resistance Microscopy), on doped Ge substrates, point contacts are realized between the metal probe and the Ge surface. When contacting the Ge directly with the probe, a Shottky contact is created due to generation of a depletion layer at the Ge side. When passivating the doped Ge substrate with a mono-crystalline undoped silicon layer as claimed in the present invention, the Shottky contact is modified into a substantially Ohmic contact. Figure 8 proofs that doped Ge samples with an epitaxially grown mono-crystalline silicon layer of two monolayers thickness show an approximately Ohmic current-voltage profile compared to the samples without silicon layer. This simplifies Spreading Resistance analysis and improves it's accuracy to a high extend.

The following paragraphs constitute another way of describing the invention, and correspond to the description made in the priority document.

### Field of the invention

This invention relates to method for passivation of a semiconductor substrate other than silicon.

It also describes a semiconductor device comprising a passivated semiconductor substrate other than silicon and to a method to fabricate this device.

### Background of the invention

In microelectronics industry, a lot of different semiconductor materials are used besides Silicon (Si). For example Germanium (Ge) wafers are important substrates with technological applications in optical devices and are recently introduced as a replacement for Si substrates for advanced Integrated Circuit (IC) devices. Ge has very attractive advantages such as high mobility and compatibility with high-k and III/V materials.

Galliumarsenide (GaAs) is another example of semiconductor materials, so-called III/V materials. These are often used in optical devices such as LED's, sensors, etc.

When processing wafers containing these alternative materials, dedicated process conditions have to be developed. Especially in case of deposition of gate stacks on Ge, one has to deal with a lot of difficulties and challenges.

One of the major problems is the high interface states density at the interface between Ge substrate and gate oxide, causing bad capacitance-voltage (CV) and current density-voltage (IV) device characteristics.

Also for analysis of mentioned alternative semiconductor materials, especially in case of Spreading Resistance measurements, the problem of high interface states density influences the measurement.

A few attempts to decrease the problem of high interface states density between Ge substrate and gate oxide are known in prior art.

In "A TaN-HfO2-Ge pMOSFET with novel SiH4 surface passivation", Wu et al. teach a method for passivating a Ge layer, where an amorphous interfacial layer is deposited in SiH₄ ambient.

In US 6,352,942 Luan et al. teach a method of oxidation of Si on Ge, where a 35ₙₘ epitaxial Si layer was deposited and then oxidized by exposure to dry oxygen gas.

### Summary of the invention

In a first aspect the invention provides a method for making a passivated semiconductor substrate, according to claim 1, the method comprising the steps of
- providing a semiconductor substrate other than silicon and
- forming a silicon layer on the substrate surface,
characterized in that the silicon layer is formed lattice matched to the substrate surface.

The semiconductor substrate can comprise Ge, GaAs, any other semiconductor material other than silicon, or any combination thereof.

In a method according to the first aspect of the invention, the silicon layer has a preferable thickness of 1 to 4 monolayers. However, in certain embodiments the thickness can be higher.

In a method according to the first aspect of the invention, the silicon layer has a thickness of 1 monolayer.

A method according to the first aspect of the invention further comprises the step of rendering the semiconductor substrate free of oxides before the step of forming the silicon layer.

In a method according to the first aspect of the invention, the silicon layer is formed by epitaxial growth.

In a method according to the first aspect of the invention, the step of forming the silicon layer comprises exposure of the semiconductor substrate to silane.

In a method according to the first aspect of the invention, the step of forming the silicon layer comprises exposure of the semiconductor substrate to silane and to N₂ as carrier gas.

In a second aspect the invention describes a semiconductor substrate other than silicon, passivated according to the first aspect of the invention.

In a method according to the second aspect of the invention, the passivated substrate is suitable to be measured by Spreading Resistance analysis techniques.

In a third aspect the invention describes a semiconductor device comprising a passivated semiconductor substrate according to the first aspect of the invention.

In a fourth aspect the invention describes a method for making a transistor comprising the step of providing a passivated semiconductor substrate according to the method provided in the first aspect of the invention.

### Detailed description of the invention

To solve the problem of high interface states density, a method for making a passivated semiconductor substrate, according to claim 1, is disclosed comprising the steps of providing a semiconductor substrate other than silicon and forming a silicon layer on the semiconductor substrate surface, characterized in that the silicon layer is formed lattice matched to the substrate surface.

The semiconductor substrate can comprise Ge, GaAs, any other semiconductor material other the Si, or any combination thereof.

The thickness of the formed lattice matched silicon layer can be preferably 1 to 4 monolayers, most preferably 1. 1 monolayer should be enough to avoid contact between Ge and the gate oxide and have minimal influence on the Equivalent Oxide Thickness (EOT).

The required thickness can be obtained by providing a thicker layer than required, followed by oxidizing the silicon, or any other technique to decrease the silicon layer thickness, leaving the required number of monolayers of silicon. The required thickness can also be provided directly.

Forming the silicon layer lattice matched to the substrate surface can be done in different ways. One way is epitaxial growth of silicon. Another possibility is providing a non-epitaxial layer, followed by re-crystallization of the layer in order to make it lattice matched to the substrate surface.

The silicon layer can be provided by different chemical vapor deposition techniques using a silicon precursor e.g. silane, dichlorosilane or the like. Preferably, epitaxial growth can be used, because this technique is able to form the silicon layer directly lattice matched to the substrate surface. In case of LPCVD epitaxial growth, the silicon precursor can be silane, dichlorosilane, or the like, or a combination thereof. As a carrier gas, H₂ or preferable N₂ can be used. The deposition temperature can be 500 to 600°C and pressure between 10 and 100 torr.

Rendering the semiconductor substrate surface oxide free before forming the silicon layer can be done by subjecting the semiconductor surface to a solution containing HF, HBr, HI or any combination thereof, optionally followed by an annealing step in hydrogen ambient.

An additional advantage of the invention is that, in case of fabricating devices on semiconductor substrates other than silicon, the process flow can be simplified by changing it partially into IC processing on silicon.

### Example 1:

In order to make a Ge capacitor, a gate stack is deposited on top of the Ge channel. To avoid a high interface state density at the interface between the Ge channel and the gate oxide, the Ge surface is passivated by forming a lattice matched monolayer of silicon on top of it. This is done by growing a few monolayers of mono-crystalline silicon in an epireactor, e.g. ASM epsilon, at a temperature between 575°C, with 20 to 50sccm silane, a pressure of 40 torr and 10 to 40slm N₂ as carrier gas. This mono-crystalline silicon layer is formed lattice matched to the Ge.

In order to be able to grow epitaxially on the Ge surface and to remove all germanium oxide on top of it, a surface preparation is done. Therefore, the Ge surface is subjected to a 1% HF solution , followed by an anneal in H₂ ambient inside the chamber of the epireactor at a temperature between 650 and 850°C.

After the mono-crystalline growth of 3 monolayers of silicon, the gate oxide is fabricated. This is done by oxidizing the silicon layer thermally, thereby leaving one monolayer of silicon between the Ge and the gate oxide, followed by depositing High-k material. Figure 1 shows a TEM picture of the resulting structure. Figure 2 shows a CV measurement of a p-type Ge capacitor fabricated in 3 different ways. In case an epitaxial silicon layer is present between the Ge and the gate oxide, the CV curve shows a much more pronounced slope compared to the cases where this silicon layer is not present. This indicates that, in case of the presence of the silicon layer, the interface states density at the Ge/gate oxide interface is decreased. Figure 3 shows the IV curve of a p-type Ge capacitor fabricated with and without epitaxial silicon layer. In case the silicon layer is present, the breakdown voltage increases approximately 1 Volt.

### Example 2:

In case of Spreading Resistance analysis, e.g. SRP and SSRM, on doped Ge substrates, point contacts are realized between the metal probe and the Ge surface. When contacting the Ge directly with the probe, a Shottky contact is created due to generation of a depletion layer at the Ge side. When passivating the doped Ge substrate with a mono-crystalline undoped silicon layer, the Shottky contact is modified into a substantially Ohmic contact. Figure 4 proofs that doped Ge samples with an epitaxially grown mono-crystalline silicon layer of two monolayers thickness show an approximately Ohmic current-voltage profile compared to the samples without silicon layer. This simplifies Spreading Resistance analysis and improves it's accuracy to a high extend.

## Claims

1. A method for passivating a semiconductor substrate comprising the steps of:
- providing a substrate surface comprising a mono-crystalline semiconductor material which is not silicon,
- rendering said mono-crystalline semiconductor material free of oxides,
- forming a lattice matched silicon layer on said mono-crystalline semiconductor material, and
- oxidating at least a part of said lattice matched silicon layer, whereby after said oxidation step the silicon layer thickness is 1 to 6 monolayers, 1 to 4 monolayers , 1 to 2 monolayers, or 1 monolayer.

2. A method according to claim 1, wherein said mono-crystalline semiconductor material is Ge or GaAs.

3. A method according to claim 1 or 2, further comprising the steps of:
- forming a dielectric layer stack, and/or
- forming a gate stack.

4. A method according to any of claims 1 to 3, wherein said silicon layer is formed by epitaxial growth, and preferably by Low Pressure Chemical Vapour Deposition (LPCVD).

5. A method according to claim 4, wherein silane, dichlorosilane, trisilane or the like, or a combination thereof is/are used as silicon precursor(s).

6. A method according to claim 5, wherein N2 is used as carrier gas.

7. A method according to claim 6, wherein trisilane is used as silicon precursor and N2 is used as carrier gas.

## Patentansprüche

1. Verfahren zum Passivieren eines Halbleitersubstrats, das die Schritte umfasst:
- Bereitstellen einer Substratoberfläche, die ein monokristallines Halbleitermaterial umfasst, das nicht Silicium ist,
- Entfernen sämtlicher Oxide aus dem monokristallinen Halbleitermaterial,
- Bilden einer gitterangepassten Siliciumschicht auf dem monokristallinen Halbleitermaterial, und
- Oxidieren zumindest eines Teils der gitterangepassten Siliciumschicht, wobei die Siliciumschichtdicke nach dem Oxidationsschritt 1 bis 6 Monoschichten, 1 bis 4 Monoschichten, 1 bis 2 Monoschichten, oder 1 Monoschicht beträgt.

2. Verfahren nach Anspruch 1, wobei das monokristalline Halbleitermaterial Ge oder GaAs ist.

3. Verfahren nach Anspruch 1 oder 2, das des Weiteren die Schritte umfasst:
- Bilden eines Dielektrischen-Schicht-Stapels, und/oder
- Bilden eines Gate-Stapels.

4. Verfahren nach einem der Ansprüche 1 bis 3, wobei die Siliciumschicht durch epitaktisches Wachstum, und vorzugsweise durch chemische Niedrigdruck-Dampfabscheidung (LPCVD) gebildet wird.

5. Verfahren nach Anspruch 4, wobei Silan, Dichlorsilan, Trisilan oder dergleichen, oder eine Kombination davon als ein oder mehrere Siliciumvorläufer verwendet wird.

6. Verfahren nach Anspruch 5, wobei N2 als Trägergas verwendet wird.

7. Verfahren nach Anspruch 6, wobei Trisilan als Siliciumvorläufer verwendet wird und N2 als Trägergas verwendet wird.

## Revendications

1. Procédé pour passiver un substrat semi-conducteur, comprenant les étapes consistant à :
- disposer d'une surface de substrat comprenant un matériau semi-conducteur monocristallin qui n'est pas du silicium,
- rendre exempt d'oxydes ledit matériau semi-conducteur monocristallin,
- former une couche de silicium à réseau concordant sur ledit matériau semi-conducteur monocristallin, et
- oxyder au moins une partie de ladite couche de silicium à réseau concordant, de façon à ce qu'après ladite étape d'oxydation, l'épaisseur de la couche de silicium soit de 1 à 6 monocouches, de 1 à 4 monocouches, de 1 à 2 monocouches, ou de 1 monocouche.

2. Procédé selon la revendication 1, dans lequel ledit matériau semi-conducteur monocristallin est Ge ou GaAs.

3. Procédé selon la revendication 1 ou 2, comprenant en outre les étapes consistant à :
- former un empilement de couches diélectriques, et/ou
- former un empilement de grilles.

4. Procédé selon l'une quelconque des revendications 1 à 3, dans lequel ladite couche de silicium est formée par croissance épitaxiale, et de préférence par dépôt chimique en phase vapeur à faible pression (LPCVD).

5. Procédé selon la revendication 4, dans lequel du silane, du dichlorosilane, du trisilane ou analogue, ou une combinaison de ceux-ci, est/sont utilisé(s) en tant que précurseur(s) de silicium.

6. Procédé selon la revendication 5, dans lequel du N2 est utilisé en tant que gaz porteur.

7. Procédé selon la revendication 6, dans lequel du trisilane est utilisé en tant que précurseur de silicium et du N2 est utilisé en tant que gaz porteur.
